# EUROPÄISCHE PATENTANMELDUNG

(11) **EP 2 226 865 A1**
(43) Veröffentlichungstag der Anmeldung: **08.09.2010**
(21) Anmeldenummer: 09003177.4
(22) Anmeldetag: 05.03.2009
(51) Int. Cl.: H01L 41/18, H01L 41/22, H01L 37/02, C04B 35/634

(54) **Piezo- und/oder pyroelektrischer Verbundwerkstoff, Verwendung des Verbundwerkstoffes sowie Herstellungsverfahren dafür**

(71) Anmelder: ZYRUS Beteiligungsgesellschaft mbH & Co. Patente I KG, 12529 Schönefeld / OT Waltersdorf (DE)
(72) Erfinder: Es-Souni, Mohammed, 24247 Mielkendorf (DE)
(74) Vertreter: Rohnke, Christian

(57) **Zusammenfassung**

Erfindungsgemäß ist ein piezo- **und/oder pyroelektrischer** Verbundwerkstoff,
mit einer ersten Keramikmaterial aufweisenden Komponente und einer zweiten ein Polymer aufweisenden Komponente,
**dadurch gekennzeichnet, dass**
die erste Komponente mit einem Metall, insbesondere Silber, modifiziert ist und/oder
die insbesondere strukturell unterschiedliche zweite Komponente mit Kohlenstoff, insbesondere Graphit, modifiziert ist.

## Beschreibung

Die vorliegende Erfindung betrifft einen piezo- und/oder pyroelektrischen Verbundwerkstoff mit einer ersten Keramikmaterial aufweisenden Komponente und einer zweiten ein Polymer aufweisenden Komponente.

### Stand der Technik

Aus dem Stand der Technik ist bekannt, dass Piezokeramiken für verschiedenste Aufgaben unter extremen Bedingungen eingesetzt werden. Beispielsweise sind Tintenstrahldrucker vielfach mit piezokeramischen Kapillarröhrchen ausgeführt, in denen sich die zu verwendende Tinte befindet. Durch piezoelektrische Anregung des piezoelektrischen Materials erfährt dieses eine Kontraktion, sodass die in dem Kapillarröhrchen befindliche Tinte ausgespritzt wird. Weiterhin sind Piezokeramiken für den Einsatz von Sensoren bekannt. Die Sensoren müssen dazu aus Werkstoffen mit hoher piezoelektrischer Aktivität bei vorzugsweise hoher thermischer und/oder zeitlicher Stabilität bestehen.

Ferner sind aus dem Stand der Technik Herstellungsverfahren bekannt, bei denen Piezokeramikpulver unter einer Wärmebehandlung von Temperaturen oberhalb von 600 °C zu festen bzw. genügend formstabilen Körpern gesintert werden.

Die WO 2007/007830 beschreibt ein Verfahren zur Herstellung von piezo- oder pyroelektrischen Dünnschichten auf einem Substrat. Hierzu werden zunächst eine Polymerlösung und eine Keramiksuspension erzeugt. Durch Vermischen der Lösung mit der Suspension entsteht ein Kompositschlicker, der mit bekannten Beschichtungsverfahren, wie beispielsweise mit dem Spincoating, in sehr dünne Schichten auf das Substrat aufgebracht werden kann. Nach dem Aufbringen wird die Schlickerschicht bei einer Temperatur um 100°C getrocknet.

### Aufgabenstellung

Es ist die Aufgabe der vorliegenden Erfindung, einen modifizierten piezo- und/oder pyroelektrischen Verbundwerkstoff mit mindestens zwei Komponenten bereitzustellen, der gegenüber dem Stand der Technik mit einer geringeren elektrischen Feldstärke polarisierbar ist und bei Temperaturen von unterhalb 600°C, vorzugsweise 300°C, herstellbar ist.

Ein weiterer Aspekt der Aufgabe ist es, dass der piezo- und/oder pyroelektrische Verbundwerkstoff nicht gesintert und dass das Verfahren zur Herstellung eines piezo- und/oder pyroelektrischen Verbundwerkstoffes keinen Sinterschritt umfassen muss. Sintern meint, dass der Werkstoff selbst einer Wärmebehandlung mit einer Temperatur von 600°C oder mehr ausgesetzt ist oder dass das Herstellungsverfahren einen Verfahrensschritt mit einer Temperatur von mindestens 600 °C umfasst.

### Lösung der Aufgabe

Gelöst wird die Aufgabe durch einen piezo- und/oder pyroelektrischen Verbundwerkstoff mit insbesondere mindestens einer ersten Keramikmaterial aufweisenden Komponente und insbesondere mindestens einer zweiten ein Polymer aufweisenden Komponente, wobei die erste Komponente mit einem Metall, insbesondere Silber, modifiziert ist und/oder die insbesondere strukturell unterschiedliche zweite Komponente mit Kohlenstoff, insbesondere Graphit, modifiziert ist.

Unter einem Verbundwerkstoff im Sinne dieser Erfindung kann sowohl ein fester Stoff als auch ein viskoser, breiiger, flüssiger verstanden werden. Denn der erfinderische Gedanke umfass Halbfabrikate genau so wie Fertigfabrikate sowie die Verwendung dieser Fabrikate als auch die Herstellungsverfahren dafür.

Unter einem Modifizieren der ersten Komponente mit einem Metall kann insbesondere verstanden werden, dass das Metall mit der ersten Komponente vermischt, verrührt, dispergiert und/oder suspendiert ist. Ferner kann die erste Komponente auch durch Aufdampfen, Sputtern, Begasen, Sprühen des Metalls modifiziert sein. Denkbar ist aber beispielsweise auch, dass die erste Komponente mit einem Metall sowie weiteren Zusatzstoffen, insbesondere einer Flüssigkeit, vorzugsweise einem Lösungsmittel wie beispielsweise Ethanol, Methanol, deren Derivate und/oder Ketone, vermischt, verrührt, dispergiert und/oder suspendiert ist.

Erfindungsgemäß unterscheiden sich die erste und die zweite Komponente vorzugsweise strukturell, also in ihrer chemischen Struktur. Sie können dann aber dennoch die gleiche Summenformel aufweisen. Sie unterscheiden sich dann zum Beispiel in ihren chemischen und/oder physikalischen Eigenschaften.

In vorteilhafter Ausgestaltung weist der Verbundwerkstoff eine Konsistenz, Dichte und/oder Viskosität auf, die dazu geeignet ist, den Verbundwerkstoff zur Herstellung von Folien und/oder zur Herstellung von Dünn- oder Dickschichten auf Substraten zu verwenden. Die Viskosität kann zum Schlickergiessen zwischen 0,01 - 10 Pa*s liegen. Weiterhin kann der Schlicker ein strukturviskoses Verhalten aufweisen. Vorteilhaft ist der Verbundwerkstoff hierzu schlickerförmig. Ein schlickerförmiger Verbundwerkstoff besteht vorzugsweise sodann aus mehreren Komponenten, die insbesondere eine breiige und/oder fließfähige Masse bilden.

In einer anderen Ausgestaltung kann es von Vorteil sein, wenn der Verbundwerkstoff im wesentlichen formbeständig ist. Insbesondere sollte sich der Verbundwerkstoff dazu eignen, mit anderen im wesentlichen beständigen Körpern kraft- und/oder formschlüssig und insbesondere auch stoffschlüssig verbunden werden zu können. Der Verbundwerkstoff ist deshalb vorzugsweise fest oder kann einen festen Aggregatzustand aufweisen. Feste piezo- und/oder pyroelektrische Verbundwerkstoffe eignen sich insbesondere dazu, Teil eines Sensors zu sein. Sensoren in diesem Sinne sind beispielsweise Kraft-, Weg-, Beschleunigungs- oder Temperatursensoren.

Die zuvor genannten Aspekte gelten in analoger Betrachtungsweise auch für Aktuatoren aus piezo- und/oder pyroelektrischen Verbundwerkstoffen.

Ferner ist es besonders vorteilhaft, die Komponenten des piezo- und/oder pyroelektrischen Verbundwerkstoffes in der Weise zu wählen, dass sie dazu geeignet sind oder sein können, dass der Verbundwerkstoff piezo- und/oder pyroelektrische Eigenschaften aufweist. Besonders bevorzugt ist hierzu eine keramische erste Komponente. Eine keramische oder aus keramischen Bestandteilen bestehende erste Komponente kann bereits piezo- und/oder pyroelektrisch sein und/oder dazu geeignet sein, piezo- und/oder pyroelektrische Eigenschaften zu erhalten. Besonders vorteilhaft ist dazu eine erste Komponente mit einer Perowskit-Grundstruktur. Auch geeignet sind keramische Materialen als erste Komponente, die eine Perowskit-Grundstruktur aufgeprägt bekommen können. Außerdem sind jene Materialien als erste Komponente bevorzugt, die einen unsymmetrischen Kristallaufbau aufweisen und insbesondere kein Symmetriezentrum im Kristall aufweisen. Denn vorteilhaft kann eine äußere mechanische Beanspruchung einer ersten Komponente mit unsymmetrischem Kristallaufbau eine Trennung ihrer positiven und negativen Ladungsschwerpunkte, insbesondere in jeder Elementarzelle, erfahren. Dieser Effekt ist vielfach richtungsabhängig und kann Ladung auf Außenflächen des Kristalls verschieben. Insbesondere in Abhängigkeit der mechanischen Beanspruchung (Druck oder Zug) können die Feldstärken und/oder Spannungen ein entgegen gesetztes Vorzeichen aufweisen. Dieser Effekt ist vorzugweise auch reziprok. Insbesondere kann ein Anlegen einer elektrischen Spannung bzw. eines elektrischen Feldes zu einer mechanischen, elastische Spannung im Kristall, insbesondere zu einer Verkürzung oder Verlängerung, führen.

Besonders bevorzugt weist die erste Komponente ein Material mit einer tetragonalen Struktur unterhalb der Curie-Temperatur auf, sodass vorzugweise die Ladungsschwerpunkte dieses Materials nicht mehr zusammenfallen und insbesondere jede Elementarzelle diese Materials einen elektrischen Dipol aufweist. Bevorzugt sind die elektrischen Dipole der Elementarzellen im wesentlichen einheitlich ausgerichtet, wobei die Ausrichtung vorzugsweise auch durch elektrische Polarisation erfolgen kann. Die Polarisation kann vorzugweise am Ende eines Herstellungsprozesses stattfinden.

Ein weiterer Vorteil der Erfindung kann darin bestehen, dass der piezo- und/oder pyroelektrische Verbundwerkstoff nicht bei hohen Temperaturen, insbesondere nicht bei Temperaturen, die aus dem Bereich des Sinterns von Keramiken bekannt sind, die insbesondere im Bereich von 600 bis 1200°C sind, hergestellt wird. In vorteilhafter Ausgestaltung ist dazu die zweite Komponente ein Polymer. Ein bevorzugter fester piezo- und/oder pyroelektrischer Verbundwerkstoff kann also insbesondere eine keramische erste Komponente und einen Polymer als zweite Komponente aufweisen. Insbesondere für einen schlickerförmigen piezo- und/oder pyroelektrischen Verbundwerkstoff kann die zweite Komponente ein Monomer oder aus einem Monomer hergestellt sein, das vorzugsweise polymerisierbar ist, und/oder eine vorzugsweise keramische erste Komponente aufweisen. Der schlickerförmige Verbundwerkstoff eignet sich insbesondere zur Herstellung von Folien sowie zur Herstellung von Dünn- oder Dickschichten auf Substraten.

Ein weitere Vorteil der Erfindung kann darin bestehen, dass eine Polarisation des Verbundwerkstoffes möglichst effektiv und/oder wirkungsvoll erfolgen kann. Besonders bevorzugt ist, den Werkstoff mit einem niedrigen elektrischem Feld, insbesondere mit Werten zwischen 1 MV/m und 50 MV/m, zu polarisieren. Zwar wird bevorzugt, dass eine erste Komponente eine höhere relative Permittivität als die zweite Komponente aufweist, jedoch wird ferner besonders bevorzugt, dass ein Quotient der relativen Permittivitäten der ersten zu der zweiten Komponente kleiner als 500, insbesondere kleiner als 300, 200, 100, 75, 50, 25, 10 und vorzugsweise kleiner als 30 ist. Die relative Permittivität einer Komponente ist vorzugsweise bezogen auf den (über das Volumen der Komponente gemittelten) Durchschnittswert der relativen Permittivität einer Komponente. Weniger bevorzugt könnten auch die Maximalwerte der relativen Permittivitäten der Komponenten zur Quotientenbildung verwendet werden.

Durch einen möglichst niedrigen Quotienten von der relativen Permittivität der ersten Komponente zu der relativen Permittivität der zweiten Komponente kann erreicht werden, dass eine außen am Werkstoff anliegende Spannung ein elektrisches Feld im Verbundwerkstoff hervorruft, wobei sich die elektrische Feldstärke reziprok zu der jeweiligen relativen Permittivität verhält. Eine Senkung des Quotient der relativen Permittivitäten trägt dazu bei, dass bei einer gleichen, außen am Werkstoff anliegenden Spannung sich das daraus resultierende elektrische Feld in der ersten Komponente stärker und in der zweiten Komponente schwächer ausprägt. Bevorzugt ist, die erste und/oder zweite Komponente des piezo- und/oder pyroelektrischen Verbundwerkstoffes insbesondere durch ein Corona-, Kontakt- oder Wechselfeld-Polungsverfahren vorzugsweise remanent zu polarisieren.

Es wurde bereits ausgeführt, dass es besonders vorteilhaft ist, den piezo- und/oder pyroelektrischen Verbundwerkstoff nicht durch ein Herstellungsverfahren mit hohen Prozesstemperaturen insbesondere bei Temperaturen oberhalb von 600°C, und/oder nicht nach einem Sinterverfahren herzustellen. Um dennoch einen hohen Zusammenhalt der Komponenten zu erreichen, ist die erste Komponente körnig und/oder pulverförmig mit vorzugsweise einer Korngröße um oder kleiner als 1 Mikrometer, insbesondere um oder kleiner als 0,6 Mikrometer. Die Zwischenräume zwischen den Körnern der ersten Komponente werden vorzugsweise durch die zweite Komponente geschlossen, insbesondere so, dass ein hoher Zusammenhalt zwischen den Komponenten entsteht. Besonders bevorzugt werden also die körnigen und/oder pulverförmigen keramischen Bestandteile des Verbundwerkstoffes von den polymeren Bestandteilen des Verbundwerkstoffes im wesentlichen umschlossen.

Auch zur Erhöhung des Zusammenhaltes der Komponenten existiert zwischen der ersten und der zweiten Komponente eine schwache elektrostatische Bindung, insbesondere eine van-der-Waals-Bindung. Ist die Keramik beziehungsweise die keramischen Teilchen von dem Polymer beziehungsweise den Polymerteilchen zumindest teilweise umschlossen, von diesem oder diesen kontaktiert oder in dem Polymer dispergiert, so können zwischen der Keramik beziehungsweise den Keramikteilchen und dem Polymer beziehungsweise den Polymerteilchen schwache van-der-Waals-Bindungen oder schwache elektrostatische Bindungen bestehen.

Ein weiterer Vorteil einer Ausgestaltung der Erfindung ist die verbesserte Polarisierbarkeit des piezo- und/oder pyroelektrischen Verbundwerkstoffes, ohne die Summenformel der ersten Komponente oder der keramischen Komponente des piezo- und/oder pyroelektrischen Verbundstoffes zu verändern. In einer ersten bevorzugten Ausgestaltung ist die erste Komponente mit einem Metall modifiziert, wobei die erste Komponente insbesondere eine Keramik, vorzugweise eine piezo-, pyro- und/oder ferroelektrische Keramik wie beispielsweise Barium-Titanat, Blei-Magnesium-Niobat-Titanat, Kalium-Natrium-Niobat, Barium-Strontium-Niobat, Bleizirkonattitanat oder mindestens eine deren dotierten Varianten, ist, und das Metall insbesondere Silber oder Silbernitrat ist. Weiterhin ist es bevorzugt, dass das Metall kein Substitut für ein vorzugweise metallisches Element der ersten Komponente ist. Denn vorteilhaft können die Teilchen oder Körner der ersten Komponente von dem Metall im Wesentlichen nicht umschlossen sein. Auch kann es bevorzugt sein, dass das Metall mit den Teilchen oder den Körnern der ersten Komponenten nur partiell verbunden und/oder kontaktiert ist. Insbesondere kann das Metall Nanoteilchen aufweisen, die mit der Oberfläche, vorzugsweise aber nur mit einem Teil der Oberfläche, der Keramik beziehungsweise Keramikteilchen in Kontakt ist. Der Übergang von Metall zu Keramik kann vorzugsweise ein Schottky (Nano-)Übergang sein. Denn insbesondere durch die hohe Arbeitsfunktion des Metalls können Elektronen in Richtung der Metall-Nanoteilchen fließen, um das Fermi-Niveau der beiden Komponenten einzuebnen. Die Keramik kann vorzugsweise deshalb eine verarmte Zone aufweisen. Ein durch eine veramte Zone der Keramik hervorgerufenes inneres elektrisches Feld kann vorteilhaft dazu verwendet werden, dass es die Polarisierung durch ein äußeres elektrisches Feld unterstützt. Denn das äußere und das innere elektrische Feld können in der Weise superpositioniert werden, dass sich ihre Feldrichtungen im Wesentlichen und/oder gemittelt über einen Volumenabschnitt übereinstimmend überlagern und sich die vorzugsweise resultierende Feldstärke erhöht. Mit "erhöht" in diesem Sinne ist gemeint, dass die resultierende Feldstärke höher ist, als eine ohne das innere elektrische Feld entstehende Feldstärke.

Wesentlich für die zuletzt genannten Ausgestaltungen ist, dass die erste Komponente mit einem Metall modifiziert ist, aber die übrigen Bestandteile der ersten Komponente, also vorzugsweise alle Bestandteile der ersten Komponente außer das Metall, in ihrer Summenformel im wesentlichen unverändert sind. So kann die keramische erste Komponente mit einem Metall, insbesondere Silber oder Silbernitrat, modifiziert sein, ohne dass sich die Summenformel der keramischen Bestandteile ändert. Denn vorzugsweise herrscht zwischen dem Metall, insbesondere dem Silber oder Silbernitrat, und den restlichen Bestandteilen der ersten Komponente, insbesondere der Keramik, keine kovalente oder ionische Bindung vor.

Ein weiterer positiver Effekt dieser Modifizierung ist, dass die Feldstärke in der modifizierten ersten Komponente im relativen Verhältnis zu einer nicht modifiziertenersten Komponente stärker ausfallen. Dieser Vorteil fällt insbesondere dann stark aus, wenn das Metall ein Übergangsmetall, insbesondere mit einer Ordnungszahl aus dem Bereich von 21 bis 30, 39 bis 48, 57 bis 80 oder 89 bis 112 und/oder besonders bevorzugt ein Edelmetall, insbesondere Silber, Gold, Platin, Palladium und/oder Rhenium ist. Insbesondere eignen sich als Metall zur Modifizierung der ersten Komponente Salze, die durch Anionen und Kationen aufgebaut sind, wobei die Kationen auch durch ein Metall gebildet sein können. Weiterhin ist es bevorzugt, dass die Salze thermisch und/oder photokatalytisch, vorzugsweise ohne Bildung von Oxiden, reduziert sind oder reduzierbar sind. Das Metall hat insbesondere eine Teilchengröße bis zu 50 Nanometer, vorzugsweise jedoch eine Teilchengröße bis zu 25 Nanometer, insbesondere bis zu oder um 10 Nanometer. Für einen insbesondere schlickerförmigen oder festen piezo- und/oder pyroelektrischen Verbundwerkstoff gilt, dass sich die Metalle vorzugsweise an die insbesondere körnige ersten Komponente, insbesondere keramische erste Komponente, "anheften". Denn vorzugsweise ziehen sich die erste Komponente und das mit ihr zu modifizierende Metall zumindest an ihren Grenzflächen elektrostatisch an.

Ferner ist es eine vorteilhafte Ausgestaltung der Erfindung, dass die zweite Komponente ein Thermoplast, insbesondere ein thermoplastisches Polymer und bevorzugt Polyvinylidenfluorid-Trifluorethylen (PVDF-TrFE) oder ein Derivat davon aufweist. Außerdem sind die Thermoplasten bevorzugt, die in einem Lösungsmittel gelöst werden können. Thermoplaste haben den Vorteil, dass sie ab einer bestimmten Temperatur (thermoplastisch) verformbar sind, und bei Unterschreiten der bestimmten Temperatur, insbesondere durch Abkühlung, wieder fest werden. Ein insbesondere fester piezo- und/oder pyroelektrischer Verbundwerkstoff kann durch die zuletzt genannte erfinderische Ausgestaltung insbesondere beliebig oft und wiederholt an eine bevorzugte Form angepasst werden.

Es ist weiter bevorzugt, dass die Polarisierbarkeit der ersten Komponente des Verbundwerkstoffes durch eine Beeinflussung der zweiten Komponente vereinfacht werden kann. Dies wäre insbesondere dann einfacher, wenn die zur Polarisation anzulegende elektrische Spannung möglichst gering ausfällt. Zur Lösung kann die insbesondere strukturell zu der ersten Komponente unterschiedliche zweite Komponente des piezo- und/oder pyroelektrischen Verbundwerkstoffes mit einem Kohlenstoff, insbesondere Graphit, modifiziert sein. Eine Modifizierung der zweiten Komponente mit einem Kohlenstoff, insbesondere Graphit und/oder Polyurethan, kann zu einer Erhöhung der Leitfähigkeit der zweiten Komponente führen. Bei einer außen an den piezo- und/oder pyroelektrischen Verbundwerkstoff angelegten Spannung kann eine Erhöhung der Leitfähigkeit in der zweiten Komponente dazu führen, dass die elektrische Feldstärke in der zweiten Komponente sinkt und die elektrische Feldstärke in den übrigen Komponenten, insbesondere in der ersten Komponente, steigt. Die Modifizierung der zweiten Komponente kann deshalb in der Art ausgestaltet sein, dass es bei einer gleichen außen angelegten Spannung an den piezo- und/oder pyroelektrischen Verbundwerkstoff zu einer verbesserten Polarisierung der ersten Komponente kommt, insbesondere weil die elektrische Feldstärke in der ersten Komponente höher ausfällt. Dieser Effekt ist besonders relevant, wenn der Quotient aus der relativen Permittivität der ersten Komponente zu der relativen Permittivität der zweiten Komponente in einem Bereich von 2 bis 500 ist. Denn unter dem zuvor erläuterten Zusammenhang steht die Polarisierbarkeit der ersten Komponente in einem reziproken Verhältnis zu dem bereits eingeführten Quotienten der relativen Permittivitäten. Eine Verringerung des Quotienten führt deshalb vorzugsweise zu einer einfacheren Polarisierbarkeit der ersten Komponente und zu einer etwas schlechteren Polarisierbarkeit der zweiten Komponente des Verbundwerkstoffes, wobei es sich jedoch schon aus dem Quotienten ergibt, dass die Polarisierbarkeit des gesamten Werkstoffes im Wesentlichen von der Polarisierbarkeit der ersten Komponente dominiert wird. Eine Verbesserung der Polarisierbarkeit der ersten Komponente kann somit auch die Polarisierbarkeit des Verbundwerkstoffes bestimmend verbessern.

Oftmals liegt Kohlenstoff nicht in elementarer Form vor. In einer besonders bevorzugten Ausgestaltung kann die zweite Komponente deshalb mit Kohlenstoff modifiziert sein, wobei an dem Kohlenstoff ein anderer Stoff oder eine andere Stoffgruppe gebunden ist. Diese anderen Stoffe oder Stoffgruppen können insbesondere Wasserstoff und/oder Kohlenwasserstoffe sein. Ferner kann der Kohlenstoff auch Verbindungselement eines Monomers oder Polymers sein.

Ein weiterer erfindungsgemäßer Aspekt ist die Verwendung des insbesondere schlickerförmigen piezo- und/oder pyroelektrischen Verbundwerkstoffes zur Herstellung eines piezo- und/oder pyroelektrischen Materials. Unter Herstellung können insbesondere alle bekannten Verfahren zur Formgebung oder zur Herstellung von Keramiken verstanden werden, bei denen vorzugsweise der Verbundwerkstoff bei einer Temperatur von unter 300°C, insbesondere unter 275, 250, 225, 200, 150, 125, 100, 75 oder 60°C, vorzugweise unter 150°C getrocknet werden kann. Vorteilhaft kann der Verbundwerkstoff deshalb auch für Herstellungsprozesse mit einer begrenzten maximalen Temperatur von insbesondere 150°C verwendet werden. Dies gilt insbesondere zur Herstellung von Sensoren oder integrierten Schaltungen, wobei erfindungsfremde Komponenten dieser beispielsweise integrierten Schaltungen oder Sensoren eine maximal zulässige Herstellungstemperatur bestimmen.

Weiterhin erfindungsgemäß ist ein Verfahren zur Herstellung eines piezo- und/oder pyroelektrischen Verbundwerkstoffes mit insbesondere mindestens einer ersten Keramikmaterial aufweisenden Komponente und insbesondere mindestens einer zweiten ein Polymer aufweisenden Komponente. Das Verfahren ist gekennzeichnet durch ein Modifizieren der ersten Komponente mit einem Metall, insbesondere Silber, und/oder durch ein Modifizieren der insbesondere strukturell unterschiedlichen zweiten Komponente mit Kohlenstoff, insbesondere Graphit, und durch ein Vermischen der ersten und zweiten Komponente zu einem Kompositschlicker und durch ein Trocknen des Kompositschlickers.

Unter einem Modifizieren der ersten Komponente mit einem Metall kann insbesondere verstanden werden, dass die ersten Komponente mit dem Metall, insbesondere Silber und/oder Silbernitrat, vermischt wird. Denkbar ist aber beispielsweise auch, dass die erste Komponente mit einem Metall sowie weiteren Zusatzstoffen, insbesondere einer Flüssigkeit, vorzugsweise einem Lösungsmittel wie beispielsweise Ethanol, vermischt wird. In einer vorteilhaften Ausgestaltung wird die mit Metall vermischte erste Komponente durch Ultraschall dispergiert.

Unter dem Verfahrensschritt "Mischen" können insbesondere die aus dem Stand der Technik bekannten üblichen Mischverfahren, insbesondere mittels Rührmischer, Einwellenmischer, Doppelwellenmischer, Mehrwellenmischer, Trommelmischer, Tellermischer, Rohrmischer, Konusmischer, Vakuummischer, Suspensionsmischer und/oder Ultraschallmischer, verstanden werden. Auch kann unter dem Modifizieren der ersten Komponente mit einem Metall ein Zerkleinerungs-Verfahrensschritt, insbesondere Mahlen, verstanden werden, wobei die erste Komponente und das Metall auf eine bestimmte Teilchen- oder Korngröße verkleinert werden können.

Die für das "Modifizieren" geltenden Eigenschaften und/oder Merkmale gelten soweit es sinnvoll ist, auch für das "modifiziert" des piezo- und/oder pyroelektrischen Verbundwerkstoff und umgekehrt. Weiterhin können auch die Merkmale der vorteilhaften Ausgestaltungen des piezo- und/oder pyroelektrischen Verbundwerkstoff, insbesondere seiner ersten und zweiten Komponente, vorteilhafte Merkmale oder Ausgestaltungen des Verfahren zur Herstellung eines piezo- und/oder pyroelektrischen Verbundwerkstoffes sein.

In einer vorteilhaften Ausgestaltung kann die erste Komponente vor, während oder nach ihrer Modifizierung, vorzugsweise aber vor dem Vermischen mit der zweiten Komponente, hydrophobiert werden. Alternativ, jedoch weniger bevorzugt, kann die erste Komponente auch während des Mischens hydrophobiert werden. Die Hydrophobierung kann durch mehrstündiges Kochen der ersten Komponente mit Ölsäure in Oktan erreicht werden. Des Weiteren können Dispergierhilfsmittel wie Igepal CO210 verwendet werden, die zur Hydrophobierung der Oberfläche beitragen. Eine erste insbesondere hydrophobe beziehungsweise hydrophobierte Komponente kann dann auch in einem insbesondere organischen Lösungsmittel, in der vorzugsweise auch die zweite Komponente lösbar ist, gelöst werden. In einer vorteilhaften Ausgestaltung ist die erste Komponente deshalb kompatibel zu der zweiten Komponente und/oder einem Lösungsmittel der zweiten Komponente. Ferner ist es vorteilhaft, wenn die zweite Komponente in einem vorzugsweise organischen Lösungsmittel, insbesondere Polymerlösung, gelöst werden kann. So können die erste und zweite Komponente in einem für beide Komponenten im wesentlichen kompatiblen Lösungsmittel gelöst, dispergiert und/oder suspendiert werden.

Es ist erfindungsgemäß, dass die zweite Komponente mit einem Kohlenstoff modifiziert wird. Die zweite Komponente kann ein Granulat oder ein Pulver vorzugsweise mit einer Korngröße im Bereich von 10 bis 100 Mikrometern sein. Der die zweite Komponente zu modifizierende Kohlenstoff, insbesondere Graphit, kann eine Korngröße im Bereich von 50 bis 100 Nanometer aufweisen. Analog zu der Modifizierung der ersten Komponente, kann hierunter ein Mischen, Zerkleinern und/oder Dispergieren verstanden werden. Insbesondere ist oder wird die zweite Komponente in dem Kohlenstoff dispergiert. Ebenfalls können hier die genannten Mischverfahren oder Zerkleinerungsverfahren Anwendung finden.

Es ist beispielsweise denkbar, dass nur eine der beiden Komponenten, also entweder nur die erste oder nur die zweite Komponente modifiziert ist oder wird. Besonders bevorzugt ist es jedoch, dass beide Komponenten modifiziert werden.

Bezüglich der Reihenfolge der Verfahrensschritte kann es bevorzugt sein, die erste Komponente vor der zweiten Komponente zu modifizieren. Es ist aber auch denkbar, dass beide Komponenten zeitlich entkoppelt voneinander modifiziert werden, also beispielsweise beide Komponenten gleichzeitig modifiziert werden oder die zweite Komponente vor der ersten Komponente modifiziert wird. Auch kann es vorteilhaft sein, die erste und/oder die zweite Komponente während des Vermischens der ersten und der zweiten Komponente zu einem Kompositschlicker zu modifizieren. Ein Modifizieren während des Mischens der Komponenten zu einem Kompositschlicker könnte insbesondere zu einer Zeitersparnis führen. Ferner könnte es den Vorteil haben, dass das Metall sowohl die erste als auch eine zweite Komponente modifiziert und/oder der Kohlenstoff die zweite und die erste Komponente modifiziert. Es könnte somit zu einer Mehrfachmodifizierung der Komponenten kommen. Weiter könnte beispielsweise das Metall die relative Permittivität der ersten Komponente herabsetzen und vorzugsweise die Leitfähigkeit einer zweiten Komponente erhöhen. Dies hätte zur Folge, dass die erste Komponente besser polarisierbar ist, insbesondere weil sich ein elektrisches Feld stärker in dem keramischen Bereich des herzustellenden Verbundwerkstoffes ausbilden kann.

Nach dem Vermischen der ersten und der zweiten Komponente zu einem Kompositschlicker folgt ein Trocknen des Kompositschlickers. Getrocknet wird vorzugsweise bei einer Temperatur von unter 300°C, insbesondere unter 275, 250, 225, 200, 150, 125, 100, 75 oder 60°C, vorzugsweise unter 150°C. Es ist bevorzugt, die Trocknungstemperatur deutlich unterhalb der gewöhnlichen Sintertemperaturen zu halten, um das Verfahren auch dann anwenden zu können, wenn es zumindest betriebswirtschaftlich unvermeidbar ist, dass auch andere Bauteile, insbesondere mit dem herzustellenden Verbundwerkstoff in Verbindung beabsichtigt stehende Bauelemente, der Trocknung und insbesondere der bei der Trocknung auftretenden Temperatur ausgesetzt sind. Insbesondere sind in diesem Sinne Sensoren und/oder integrierte Schaltungen zu berücksichtigen, die nur einer begrenzt maximalen Temperatur von vorzugsweise 250, 200 oder 150°C ausgesetzt werden können, ohne durch Überhitzung zerstört zu werden. Es ist also bevorzugt, dass die insbesondere getrocknete, mit Metall vermischte und/oder dispergierte erste Komponente nicht gesintert, insbesondere nicht bei einer Temperatur von mehr als 300 Grad Celsius gesintert wird.

In einer weiteren Ausgestaltung wird die ersten Komponente modifiziert, indem die insbesondere getrocknete, nicht gesinterte, mit Metall vermischte und/oder dispergierte erste Komponente bei einer Temperatur von maximal 200, 300, 400 oder vorzugsweise 500 Grad Celsius insbesondere durch Bestrahlung mit ultraviolettem Licht (UV-Licht) wärmebehandelt wird. Das UV-Licht kann dazu Wellenlängen aus dem Bereich von 120 bis 420 Nanometern und vorzugsweise eine an die Masse des mit Wärme zu behandelnden, getrockneten Schlickers angepasste Intensität aufweisen. Die Leistung des Lichtes kann 10 bis 250 Watt sein. Weiter kann die Wärmebehandlung beziehungsweise die Modifizierung dadurch gekennzeichnet sein, dass das Metall, insbesondere das Silbernitrat, durch das UV-Licht zu einem inerten Metall, insbesondere Silber, reduziert wird. Denn insbesondere durch Bestrahlung mit UV-Licht entstehen in der Keramik Elektronen-Loch-Paare. Die Elektronen werden so auch an die Metall-Ionen, insbesondere Silber-Ionen, transferiert und neutralisieren dieses vorzugsweise an der Oberfläche der Keramik.

In einer weiteren Vorteilhaften Ausgestaltung wird die ersten Komponente modifiziert, indem die insbesondere wärmebehandelte, getrocknete, nicht gesinterte, mit Metall vermischte und/oder dispergierte erste Komponente vorzugsweise mit einer Flüssigkeit, insbesondere mit Hexan, gemahlen wird. Durch diesen Verfahrensschritt kann die Partikelgröße verringert werden und insbesondere die während der Wärmebehandlung möglicherweise entstandenen Agglomerate zerkleinert werden.

Weiterhin kann das Modifizieren der ersten Komponente in der Weise ausgestaltet sein, dass eine Mischung aus Butylmethylketon und/oder Acetylaceton mit der insbesondere wärmebehandelte, getrocknete, nicht gesinterte, mit Metall vermischte und/oder dispergierte, mit einer Flüssigkeit, insbesondere mit Hexan, gemahlenen erste Komponente mittels Ultraschall homogenisiert wird. Vorzugsweise weisen die Lösungsmittel dafür unterschiedliche Dampfdrücke auf, welche zu einem vorteilhaften Trocknungsverhalten insbesondere dicker Schichten führen kann. Bei Verwendung eines anderen Polymers als PVDF-TrFE, können die Lösungsmittel daran angepasst sein. Auch wenn Butylmethylketon und Acetylaceton durch Rühren gleichmäßig miteinander vermischt werden könnten, gelingt dies zumeist jedoch nicht mit einem Feststoff (insbesondere aufgrund der verschiedenen Dichten). Für eine bevorzugte Ausgestaltung ist ein Ultraschall zur Vermischung deshalb in der Art ausgelegen, dass sich die Flüssigkeit in eine bestimmte Tröpfchengröße zerkleinert und so der Feststoff gleichmäßig mit der Flüssigkeit vermischt. Für eine Ultraschallbehandlung werden bevorzugt Frequenzen aus dem Bereich von etwa 20 - 100 kHz, einer Leistungsdichte von 0,01 bis 600 W/cm² und/oder einem Schalldruck aus Bereich von 0 bis 200 dB gewählt beziehungsweise angewendet. Die zuvor genannten Grundgedanken gelten im Übrigen für alle Ultraschall Verfahrensschritte.

Insbesondere in einem nachfolgenden Verfahrensschritt ist es vorteilhaft, die zweite Komponente zu modifizieren, indem die zweite Komponente mit Kohlenstoff insbesondere durch Rühren vermischt wird. Dieser Verfahrensschritt stellt eine besonders einfache Möglichkeit dar, ein Polymer mit Graphit zu modifizieren. In einer weiteren vorteilhaften Ausgestaltung eines insbesondere nachfolgenden Verfahrensschrittes kann die zweiten Komponente modifiziert werden, indem eine Mischung aus Butylmethylketon und Acetylaceton mittels Ultraschall mit Kohlenstoff homogenisiert wird und danach durch Rühren mit der zweiten Komponente insbesondere vermischt und/oder homogenisiert wird.

Da die erste und zweite Komponente sowohl feste als auch flüssige Stoffe aufweisen kann, werden die beiden Komponenten in einer bevorzugten Ausgestaltung vermischt, indem die erste und zweite Komponente mittels Ultraschall homogenisiert wird. Alternativ oder in einem nachfolgenden Verfahrensschritt können die beiden Komponenten auch vermischt werden, indem die erste und zweite Komponente durch Rühren homogenisiert wird. Zweck beider Verfahrensschritte ist eine möglichst gleichmäßige Vermischung der Komponenten beziehungsweise der Stoffe der Komponenten zu einem Kompositschlicker.

In einer vorteilhaften Ausgestaltung kann der Kompositschlicker insbesondere mittels eines Rotationsbeschichtungs-Verfahrens, insbesondere Spin-Coating, Druckverfahrens, insbesondere Flach-, Tief- und/oder Siebdruck, Sol-Gel-Verfahrens oder Sprühverfahrens auf ein insbesondere flexibles Substrat aufgebracht wird. Ein flexibles Substrat meint einen biegsamen und elastisch verformbaren Körper. Zumindest die mit dem Kompositschlicker in Kontakt tretende Oberfläche des Substrates ist bevorzugt in der Weise ausgestaltet, dass der Schlicker an ihr haften kann. Die Oberfläche des Substrates kann dazu eine ausreichend hohe Oberflächenrauheit aufweisen, so dass zwischen Schlicker und Substrat eine Formschlüssige Verbindung entsteht. Weiter kann zwischen Schlicker und Substrat auch eine stoffschlüssige Verbindung entstehen. Insbesondere zur Herstellung von mehrschichtigen Verbundwerkstoffen, kann auf den getrockneten Schlicker ein Kompositschlicker aufgebracht und danach getrocknet wird. Das Aufbringen und Trockenen kann entsprechend der Anzahl der Schichten oft wiederholt werden.

In einer weiteren bevorzugten Ausgestaltung wird der Verbundwerkstoff insbesondere nach dem Trocknen vorzugsweise remanent polarisiert. Dazu ist es besonders vorteilhaft, wenn die erste und/oder die zweite Komponente polarisierbar sind. Sofern der Verbundwerkstoff Bestandteile aufweist, die nicht polarisierbar sind, gilt die Polarisierung selbstverständlich für diese nicht. Die Polarisierung kann durch ein Aufprägen eines elektrischen Feldes auf den Verbundwerkstoff erfolgen. Dazu kann an mindestens zwei Enden ein unterschiedlich hohes elektrisches Potential angelegt werden, sodass zwischen diesen Enden eine elektrische Spannung anliegt, die vorzugsweise mehrere hundert oder mehrere tausend Volt, insbesondere im Bereich von 1000 bis 15000 Volt ist. Insbesondere eignen sich zur Polarisierung ein Corona-, Kontakt- oder Wechselfeld-Polungsverfahren.

### Figuren:

Weitere Einzelheiten, Vorteile und Merkmale der Erfindung gehen aus der nachfolgenden Beschreibung der Figuren hervor. Die Ausführungsbeispiele der Erfindung zeigen:
- **Figur 1**: einen Ablaufplan zur erfindungsgemäßen Herstellung eines modifizierten Keramikpulvers,
- **Figur 2**: zeigt einen Ablaufplan zur erfindungsgemäßen Herstellung eines Kompositschlickers mit einer modifizierten Keramik,
- **Figur 3**: zeigt einen Ablaufplan zur erfindungsgemäßen Herstellung eines Kompositschlickers mit einem modifizierten Polymer,
- **Figur 4**: zeigt einen Ablaufplan zur erfindungsgemäßen Herstellung eines Kompositschlickers mit einer modifizierten Keramik und mit einem modifizierten Polymer und
- **Figur 5**: zeigt einen Ablaufplan zur erfindungsgemäßen Herstellung einer Folie aus einem Kompositschlicker.

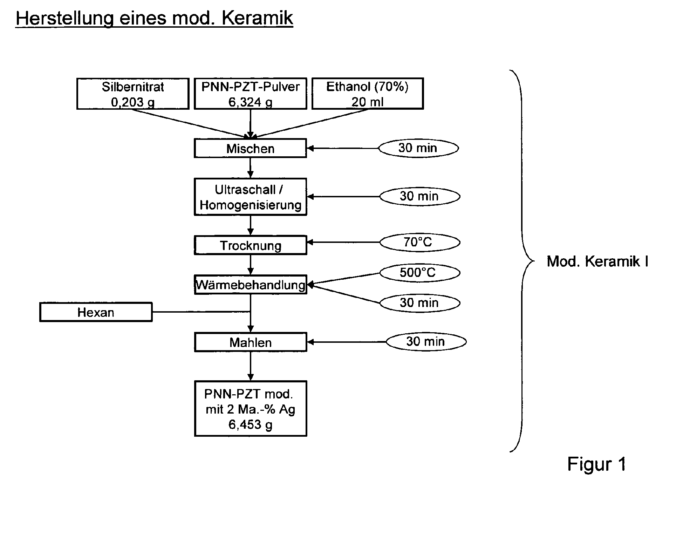

In **Figur 1** ist eine vorteilhafte Ausgestaltung der Modifizierung der ersten Komponente mit einem Metall dargestellt. Die erste Komponente ist 6,324g eines Bleinickelniobat-Bleizirkonattitanat-Pulvers (PNN-PZT-Pulver). Das Metall, mit der die erste Komponente modifiziert werden soll, ist 0,203 g Silbernitrat. Das Silbernitrat und das Bleinickelniobat-Bleizirkonattitanat-Pulver werden mit einer Flüssigkeit, insbesondere Alkohol und vorzugsweise wie in Figur 1 dargestellt, mit 20 ml eines 70 %igen Ethanols für 30 Minuten durch Rühren vermischt, sodass ein Schlicker entsteht und wobei das Silbernitrat und das PNN-PZT-Pulver in dem Ethanol gelöst und/oder dispergiert werden. Nach dem dreißigminütigen Mischen wird der so entstandene Schlicker mittels Ultraschall für 30 Minuten gemischt und/oder homogenisiert. Danach wird der Schlicker bei maximal 300°C, insbesondere unter 250, 200, 150, 100, 75 oder 60°C vorzugsweise unter 70°C getrocknet. Insbesondere wird der Schlicker nicht gesintert, und dies insbesondere auch nicht bei einer Temperatur von mehr als 300°C. Danach erfolgt für 30 Minuten eine Wärmebehandlung bei einer Temperatur von maximal 200, 300, 400 oder 500 °C, insbesondere durch Bestrahlung mit ultraviolettem Licht.

Ausgangsprodukt der Trocknung und/oder der Wärmebehandlung ist eine pulverförmige und/oder granulatförmige mit Metall modifizierte erste Komponente und entsprechend der bevorzugten Ausgestaltung aus Figur 1 ein pulverförmiges mit Silber modifiziertes PNN-PZT-Pulver. Nach der Trocknung und/oder nach der Wärmebehandlung wird das Pulver in Hexan für eine Stunde nass gemahlen. Ausgangsprodukt der Mahlung ist ein mit zwei Massenprozent Silber modifiziertes PNN-PZT.

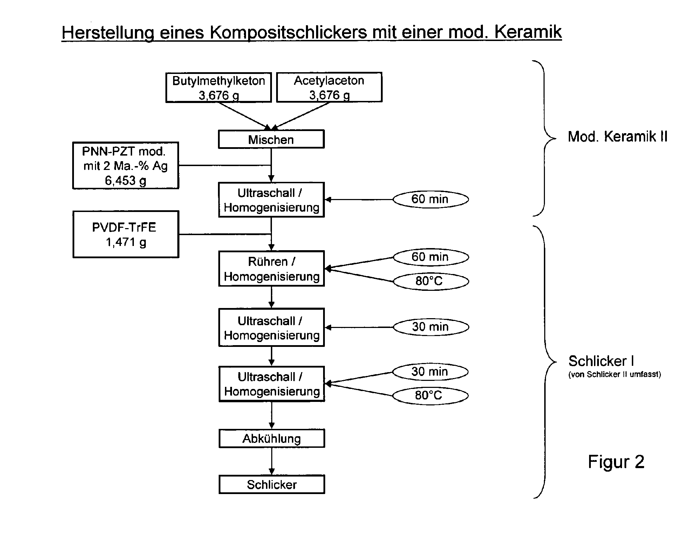

**Figur 2** stellt im Wesentlichen einen Ablaufplan zur Herstellung eines Kompositschlickers mit einer modifizierten Keramik dar. Die dargestellten und bevorzugten Verfahrensschritte umfassen zunächst ein Mischen von 3,676 g Butylmethylketon mit 3,676 g Acetylaceton. Das Mischen kann nach einem bereits genannten oder mit einem aus dem Stand der Technik bekannten Verfahren erfolgen. Das Ausgangsprodukt der Mischung wird daraufhin mit 6,453 g des mit 2 Massenprozent Silber modifizierten PNN-PZT-Pulver durch Ultraschall für 60 Minuten vermischt und/oder homogenisiert. Das Ausgangsprodukt des Ultraschall-Verfahrensschrittes ist also eine mit Silber modifizierte PNN-PZT-Keramikdispersion und/oder -suspension.

Mit anderen Worten kann das Modifizieren der ersten Komponente mit einem Metall ein Vermischen durch Rühren und/oder ein Vermischen durch Ultraschall, wobei beim Ultraschall vorzugsweise die erste Komponente und das Metall dispergiert und/oder homogenisiert werden, ein Trocknen vorzugsweise bei einer Temperatur unterhalb von 70°C, eine Wärmebehandlung durch Bestrahlung mit ultraviolettem Licht, wobei das UV-Licht das Metall zu inertem Metall reduziert, vorzugsweise bei einer Temperatur oberhalb von 200, 300, 400 oder 500°C, ein Mahlen der mit Metall vermischten und/oder dispergierten ersten Komponente vorzugsweise in einer Flüssigkeit mit Hexan und/oder eine mehrfache Wiederholung einer oder mehrerer der zuvor genannten Verfahrenschritte umfassen. Das Modifizieren der zweiten Komponente mit einem Kohlenstoff kann sinngemäß und/oder analog zu dem Modifizieren der ersten Komponente mit Metall erfolgen.

Figur 2 zeigt auch den Ablaufplan zur Herstellung eines Kompositschlickers mit einer modifizierten Keramik, die das Ausgangsprodukt der Ultraschallbehandlung war und die zusammen mit einer zweiten Komponente, nämlich 1,471 g Polyvinylidenfluorid-Trifluorethylen (PVDF-TrFE) für 60 Minuten bei 80°C durch Rühren vermischt und/oder homogenisiert wird. Daraufhin wird das Produkt des vorangegangenen Verfahrensschrittes für 30 Minuten durch Ultraschall homogenisiert und/oder vermischt. Nachfolgend wird das Produkt des vorangegangenen Verfahrensschrittes erneut durch Ultraschall für 30 Minuten bei 80°C durch Ultraschall vermischt und/oder homogenisiert. Anschließend kühlt das Produkt des vorangegangen Verfahrensschrittes ab, um einen Kompositschlicker mit einer modifizierten Keramik zu bilden.

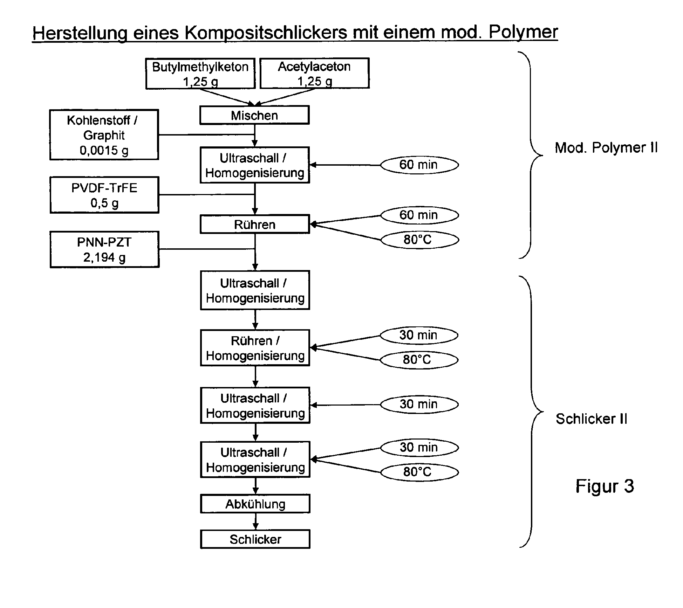

**Figur 3** zeigt den Ablaufplan zur Herstellung eines Kompositschlickers mit einem modifizierten Polymer. Insbesondere zeigt Figur 3 aber auch eine Möglichkeit zur Modifizierung einer zweiten Komponente mit einem Kohlenstoff, nämlich vorzugsweise die Modifizierung von Polyvinylidenfluorid-Trifluorethylen (PVDF-TrFE) mit Graphit.

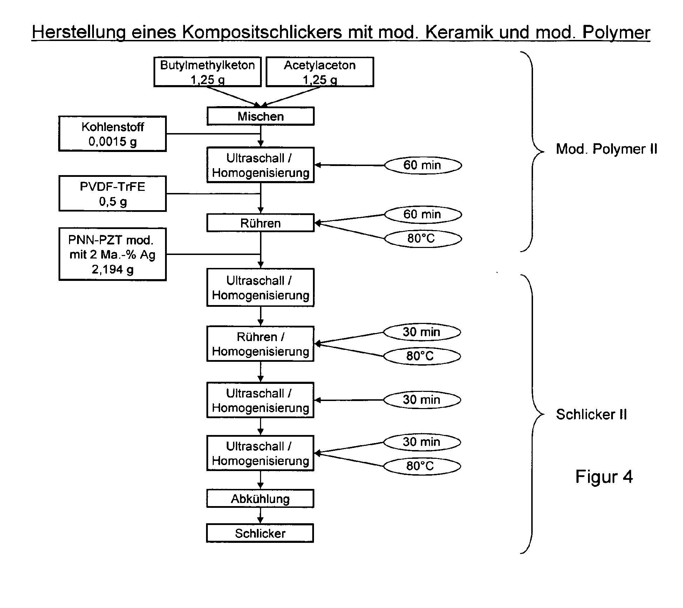

Eine Modifizierung der ersten Komponente umfasst zunächst das Vermischen von 1,25 g Butylmethylketon mit 1,25 g Acetylaceton, wobei das Ausgangsprodukt mit 0,0015 g Kohlenstoff oder Graphit für 60 Minuten durch Ultraschall homogenisiert und/oder vermischt wird. Durch ein Rühren wird das Ausgangsprodukt des vorangegangenen Verfahrensschrittes sodann mit der zweiten Komponente, nämlich 0,5 g des bevorzugten Polyvinylidenfluorid-Trifluorethylen, für 60 Minuten bei 80°C vermischt oder homogenisiert. Das Ausgangsprodukt des vorangegangenen Verfahrensschrittes wird danach mit der ersten Komponente, nämlich 2,194 g des bevorzugten PNN-PZT (-Pulvers), durch Ultraschall homogenisiert und/oder vermischt. Alternativ kann anstatt des PNN-PZT-Pulvers auch ein mit beispielsweise 2 Massenprozent Silber modifiziertes PNN-PZT-Pulver mit dem Ausgangsprodukt des vorangegangenen Verfahrensschrittes durch Ultraschall homogenisiert und/oder vermischt werden. Je nach Auswahl kann ein Kompositschlicker mit einer modifizierten Keramik und/oder mit einem modifizierten Polymer hergestellt werden. Figur 4 zeigt die explizit genannte alternative Herstellungsvariante zu Figur 3. Das Ausgangsprodukt des Ultraschall-Verfahrensschrittes wird dann durch Rühren für 30 Minuten bei 80°C vermischt und/oder homogenisiert. Anschließend erfolgt ein Homogenisieren und/oder Vermischen des Ausgangsprodukts des vorangegangenen Verfahrensschrittes für 30 Minuten durch Ultraschall. Nachfolgend wird das Ausgangsprodukt des vorangegangenen Verfahrensschrittes erneut durch Ultraschall für 30 Minuten bei 80°C homogenisiert und/oder vermischt und sodann abgekühlt, so dass ein Kompositschlicker mit einer modifizierten Keramik oder mit einem modifizierten Polymer entsteht.

Die zu den Figuren 1 bis 4 erläuterten Verfahrensschritte sind nicht zwangsläufig alle notwendig, insbesondere können auch einzelne Misch-, Ultraschall- und/oder Rühr-Verfahrensschritte entfallen und/oder in ihrer Reihenfolge getauscht werden. Ferner können die Zeit-, Temperatur- und/oder Gewichtsangaben als besonders bevorzugte Parameter aus einem Parameterintervall von +/- 40% um diese bevorzugten Parameter verstanden werden. Weiter können die Gewichtsangaben und/oder - intervalle ein Verhältnis definieren, das beispielsweise in Abhängigkeit eines gewünschten Gewichts des Ausgangsproduktes linear skaliert werden kann.

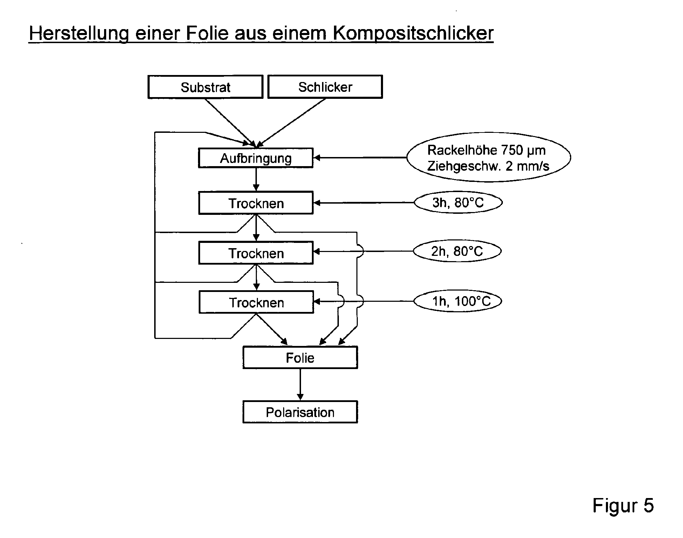

**Figur 5** zeigt den Ablaufplan zur Herstellung eines festen piezo- und/oder pyroelektrischen Verbundwerkstoffes, insbesondere einer Folie, aus einem Kompositschlicker auf einem Substrat. Der Kompositschlicker mit einer modifizierten Keramik und/oder einem modifizierten Polymer wird auf ein Substrat aufgebracht. Hierzu eignen sich vorzugsweise die aus dem Stand der Technik bekannten Aufbringungs-Verfahren, insbesondere mittels Spincoating, eines Rotationsbeschichtungs-Verfahrens, eines Druckverfahrens, insbesondere Flach-, Tief- und/oder Siebdruck, eines Sol-Gel-Verfahrens oder eines Sprühverfahrens. Bei der Herstellung von Folien mittels eines Rakels kann die Rakelhöhe 750 Mikrometer und die Ziehgeschwindigkeit 2 mm pro Sekunde betragen. Nach dem Aufbringen eines Schlickers auf ein Substrat folgen ein oder mehrere Trocknungsschritte. Wie in Figur 5 dargestellt, folgt auf das Aufbringen ein erster Trocknungsschritt bei 80°C für drei Stunden ein zweiter Trocknungsschritt für zwei Stunden bei 80°C, der wiederum gefolgt von einem dritten Trocknungsschritt bei 100°C für eine Stunde den aufgebrachten Schlicker trocknet. Auch denkbar ist, dass nach dem ersten, zweiten oder dritten Trocknungsschritt eine erneute Schlickerschicht auf das Substrat und/oder auf die zuvor aufgebrachte getrocknete Schlickerschicht aufgebracht wird. Gegenüber der getrockneten Schlickerschicht kann der Rakel wieder um 750 Mikrometer erhöht bei einer Ziehgeschwindigkeit von 2 mm pro Sekunde den Schlicker aufbringen. Alternativ ist es auch nach einem der Trocknungsschritte möglich, die sodann entstandene Folie zu verwenden und/oder die Dipole der ersten und/oder zweiten Komponente durch Polarisation auszurichten, sodass der so entstandene piezo- und/oder pyroelektrische Werkstoff bessere piezo- und/oder pyroelektrische Eigenschaften aufweist.

## Patentansprüche

1. **Piezo- und/oder pyroelektrischer Verbundwerkstoff,**
mit einer ersten Keramikmaterial aufweisenden Komponente und einer
zweiten ein Polymer aufweisenden Komponente,
**dadurch gekennzeichnet, dass**
die erste Komponente mit einem Metall, insbesondere Silber, modifiziert ist und/oder
die insbesondere strukturell unterschiedliche zweite Komponente mit Kohlenstoff, insbesondere Graphit, modifiziert ist.

2. Piezo- und/oder pyroelektrischer Verbundwerkstoff nach dem vorhergehenden Anspruch, **dadurch gekennzeichnet, dass** der Verbundwerkstoff schlickerförmig oder fest ist.

3. Piezo- und/oder pyroelektrischer Verbundwerkstoff nach einem der vorhergehenden Ansprüche, **dadurch gekennzeichnet, dass** die zweite Komponente aus einem Monomer hergestellt ist.

4. Piezo- und/oder pyroelektrischer Verbundwerkstoff nach einem der vorhergehenden Ansprüche, **dadurch gekennzeichnet, dass** die zweite Komponente eine niedrigere relative Permittivität als die erste Komponente aufweist.

5. Piezo- und/oder pyroelektrischer Verbundwerkstoff nach einem der vorhergehenden Ansprüche, **dadurch gekennzeichnet, dass** die erste Komponente eine Perowskit-Grundstruktur aufweist.

6. Piezo- und/oder pyroelektrischer Verbundwerkstoff nach einem der vorhergehenden Ansprüche, **dadurch gekennzeichnet, dass** die erste Komponente Barium-Titanat, Blei-Magnesium-Niobat-Titanat, Kalium-Natrium-Niobat, Barium-Strontium-Niobat, Bleizirkonattitanat aufweist.

7. Piezo- und/oder pyroelektrischer Verbundwerkstoff nach einem der vorhergehenden Ansprüche, **dadurch gekennzeichnet, dass** das Metall mit Teilchen oder Körnern der ersten Komponente nur partiell verbunden und/oder kontaktiert ist.

8. Piezo- und/oder pyroelektrischer Verbundwerkstoff nach einem der vorhergehenden Ansprüche, **dadurch gekennzeichnet, dass** das Metall ein Edelmetall, insbesondere Silber, Gold, Platin, Palladium und/oder Rhenium, ist.

9. Piezo- und/oder pyroelektrischer Verbundwerkstoff nach einem der vorhergehenden Ansprüche, **dadurch gekennzeichnet, dass** die zweite Komponente Polyvinylidenfluorid-Trifluorethylen (PVDF-TrFE) ist oder umfasst.

10. Piezo- und/oder pyroelektrischer Verbundwerkstoff nach einem der vorhergehenden Ansprüche, **dadurch gekennzeichnet, dass** ein Quotient der relativen Permittivität der ersten zu der zweiten Komponente kleiner als 500, insbesondere kleiner als oder gleich 300, 200, 100, 75, 50, 40, 20, 10 und vorzugsweise kleiner als oder gleich 30 ist.

11. **Verwendung** eines insbesondere schlickerförmigen Verbundwerkstoffes nach einem der vorhergehenden Ansprüche zur Herstellung eines piezo- und/oder pyroelektrischen Materials.

12. Verwendung eines insbesondere schlickerförmigen Verbundwerkstoffe nach dem vorhergehenden Anspruch, **dadurch gekennzeichnet, dass** der Verbundwerkstoff bei einer Temperatur von unter 300 Grad Celsius, insbesondere unter 275, 250, 225, 200, 150, 125, 100, 75 oder 60 Grad Celsius, vorzugsweise unter 150 Grad Celsius getrocknet wird.

13. **Verfahren**
zur Herstellung eines piezo- und/oder pyroelektrischen Verbundwerkstoffs mit einer ersten Keramikmaterial aufweisenden Komponente und einer zweiten ein Polymer aufweisenden Komponente,
**gekennzeichnet durch**
ein Modifizieren der ersten Komponente mit einem Metall, insbesondere Silber, und/oder
ein Modifizieren der insbesondere strukturell unterschiedlichen zweiten Komponente mit Kohlenstoff, insbesondere Graphit, und **durch**
ein Vermischen der ersten und zweiten Komponente zu einem Kompositschlicker und **durch**
ein Trocknen des Kompositschlickers.

14. Verfahren nach Anspruch 13, **dadurch gekennzeichnet, dass** die zweite Komponente aus einem Monomer hergestellt ist.

15. Verfahren nach einem der Ansprüche 13 bis 14, **dadurch gekennzeichnet, dass** die zweite Komponente eine niedrigere relative Permittivität als die erste Komponente aufweist.

16. Verfahren nach einem der Ansprüche 13 bis 15, **dadurch gekennzeichnet, dass** die erste Komponente eine Perowskit-Grundstruktur aufweist.

17. Verfahren nach einem der Ansprüche 13 bis 16, **dadurch gekennzeichnet, dass** die erste Komponente Barium-Titanat, Blei-Magnesium-Niobat-Titanat, Kalium-Natrium-Niobat, Barium-Strontium-Niobat, Bleizirkonattitanat aufweist.

18. Verfahren nach einem der Ansprüche 13 bis 17, **dadurch gekennzeichnet, dass** die erste Komponente körnig und/oder pulverförmig ist.

19. Verfahren nach einem der Ansprüche 13 bis 18, **dadurch gekennzeichnet, dass** das Metall mit Teilchen oder Körnern der ersten Komponente nur partiell verbunden und/oder kontaktiert ist.

20. Verfahren nach einem der Ansprüche 13 bis 19, **dadurch gekennzeichnet, dass** das Metall ein Edelmetall, insbesondere Silber, Gold, Platin, Palladium und/oder Rhenium, ist.

21. Verfahren nach einem der Ansprüche 13 bis 20, **dadurch gekennzeichnet, dass** die zweite Komponente Polyvinylidenfluorid-Trifluorethylen (PVDF-TrFE) ist oder umfasst.

22. Verfahren nach einem der Ansprüche 13 bis 21, **dadurch gekennzeichnet, dass** ein Quotient der relativen Permittivität der ersten zu der zweiten Komponente kleiner als 500, insbesondere kleiner als oder gleich 300, 200, 100, 75, 50, 40, 20, 10 und vorzugsweise kleiner als oder gleich 30 ist.

23. Verfahren nach einem der Ansprüche 13 bis 22, **dadurch gekennzeichnet, dass** die erste Komponente kompatibel zu der zweiten Komponente und/oder einem Lösungsmittel der zweiten Komponente ist.

24. Verfahren nach einem der Ansprüche 13 bis 23, **gekennzeichnet durch das** Modifizieren der ersten Komponente, wobei die erste Komponente mit einem Metall, insbesondere Silber, vorzugsweise Silbernitrat, und/oder einer Flüssigkeit, insbesondere Alkohol, vorzugsweise Ethanol, insbesondere **durch** Rühren vermischt wird.

25. Verfahren nach einem der Ansprüche 13 bis 24, **gekennzeichnet durch das** Modifizieren der ersten Komponente, wobei die mit Metall vermischte erste Komponente **durch** Ultraschall dispergiert wird.

26. Verfahren nach einem der Ansprüche 13 bis 25, **gekennzeichnet durch das** Modifizieren der ersten Komponente, wobei die mit Metall vermischte und/oder dispergierte erste Komponente unter 300, insbesondere unter 250, 200, 150, 100, 75 oder 60, vorzugsweise unter 150 Grad Celsius getrocknet wird.

27. Verfahren nach einem der Ansprüche 13 bis 26, **gekennzeichnet durch das** Modifizieren der zweiten Komponente, wobei die zweite Komponente mit Kohlenstoff insbesondere **durch** Rühren vermischt wird.

28. Verfahren nach einem der Ansprüche 13 bis 27, **gekennzeichnet durch das** Vermischen der ersten und zweiten Komponente, wobei die erste und zweite Komponente mittels Ultraschall homogenisiert wird.

29. Verfahren nach einem der Ansprüche 13 bis 28, **gekennzeichnet durch das** Vermischen der ersten und zweiten Komponente, wobei die erste und zweite Komponente **durch** Rühren homogenisiert wird.

30. Verfahren nach einem der Ansprüche 13 bis 29, **dadurch gekennzeichnet, dass** der Kompositschlicker insbesondere mittels eines Rotationsbeschichtungs-Verfahrens, insbesondere Spin-Coating, Druckverfahrens, insbesondere Flach-, Tief- und/oder Siebdruck, Sol-Gel-Verfahrens oder Sprühverfahrens auf ein insbesondere flexibles Substrat aufgebracht wird.

31. Verfahren nach einem der Ansprüche 13 bis 30, **dadurch gekennzeichnet, dass** bei einer Temperatur von unter 300 Grad Celsius, insbesondere unter 275, 250, 225, 200, 150, 125, 100, 75 oder 60 Grad Celsius, vorzugsweise unter 150 Grad Celsius getrocknet wird.

32. Verfahren nach einem der Ansprüche 13 bis 31, **dadurch gekennzeichnet, dass** auf den getrockneten Schlicker ein Kompositschlicker aufgebracht und danach getrocknet wird.
